(19) Europäisches Patentamt
European Patent Office
Office européen des brevets

(11) **EP 1 895 730 A1**

(12) **EUROPEAN PATENT APPLICATION**

(43) Date of publication:
05.03.2008 Bulletin 2008/10

(51) Int Cl.:
*H04L 25/06* (2006.01)   *H04L 25/03* (2006.01)

(21) Application number: 07251679.2

(22) Date of filing: 23.04.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: 01.09.2006 GB 0617287

(71) Applicant: **Kabushiki Kaisha Toshiba**
**Minato-ku,**
**Tokyo 105-8001 (JP)**

(72) Inventors:
• **Ponnampalam Vishakan**
  **Bristol BS1 4ND (GB)**
• **Sandall, Magnum Stig Torsten**
  **Bristol BS1 4ND (GB)**
• **Lillie, Andrew George**
  **Bristol BS1 4ND (GB)**
• **McNamara, Darren Pillip**
  **Bristol BS1 4ND (GB)**

(74) Representative: **Round, Edward Mark**
**Marks & Clerk**
**90 Long Acre**
**London WC2E 9RA (GB)**

(54) **Soft decision generation in a lattice reduction MIMO system.**

(57) In a lattice-reduction-aided receiver based wireless communications system, soft estimates of transmitted bit values are determined from a received signal by applying lattice reduction to the channel estimate and equalising the received signal in accordance with the reduced basis channel, and determining probabilities of transmitted bits having particular values by generating a set of candidate vectors in the reduced basis based on nearest candidate vectors, determining a corresponding transmitted symbol vector for each candidate vector and, on the basis of the received signal determining the probability of each transmitted bit value having been transmitted.

FIGURE 3

Start

GENERATE A LIST OF POTENTIAL CANDIDATE
VECTORS FOR THE UN-QUANTISED ESTIMATE OF
TRANSMITTED LATTICE POINT IN THE REDUCED BASIS
210

DETERMINE THE CONDITIONAL PROBABILITY OF THE
UN-QUANTISED ESTIMATE GIVEN THAT THE LIST OF
CANDIDATE VECTORS BEING EQUAL TO THE TRUE
VALUE OF TRANSMITTED LATTICE POINT IN THE
REDUCED BASIS
220

DETERMINE A SET OF NEAREST CANDIDATE VECTORS
TO THE UN-QUANTISED ESTIMATE
230

MAP EACH CANDIDATE VECTOR TO A TRANSMITTED
SYMBOL VECTOR ESTIMATE
240

CALCULATE PROBABILITY OF EACH CANDIDATE SYMBOL
VECTOR HAVING BEEN TRANSMITTED
250

CALCULATE PROBABILITIES OF SYMBOLS HAVING BEEN
TRANSMITTED FROM SPECIFIC ANTENNAS
260

DETERMINE LOG-LIKELIHOOD RATIOS FOR TRANSMITTED
BITS
270

END

FIGURE 5

**Description**

Field of the Invention

The present invention is in the field of wireless communication, and particularly, but not exclusively, the field of multiple input multiple output (MIMO) communications systems.

Background of the Invention

Conventional communication systems can be represented mathematically as:

$$\mathbf{y} = \mathbf{Hx} + \mathbf{v}$$

in which, for a MIMO communication system, $\mathbf{y}$ is an $n$-by-1 vector representing the received signal, $\mathbf{H}$ is an n-by-m channel matrix modelling the transmission characteristics of the communications channel, $\mathbf{x}$ is an $m$-by-1 vector representing transmit symbols, $\mathbf{v}$ is an $n$-by-1 noise vector and wherein $m$ and $n$ denote the number of transmit and receive antennas respectively.

It will be understood by the skilled reader that the same representation can be used for multi-user detection in CDMA systems.

Recent publications have demonstrated how the use of a technique called Lattice Reduction can improve the performance of MIMO detection methods.

For example, "Lattice-Reduction-Aided Detectors for MIMO Communication Systems", (H. Yao and G.W. Womell, Proc. IEEE Globecom, Nov 2002, pp. 424-428) describes Lattice-reduction (LR) techniques for enhancing the performance of multiple-input multiple-output (MIMO) digital communication systems.

In addition, "Low-Complexity Near-Maximum-Likelihood Detection and Precoding for MIMO Systems using Lattice Reduction", (C. Windpassinger and R. Fischer, in Proc. IEEE Information Theory Workshop, Paris, March, 2003, pp. 346-348) studies the lattice-reduction-aided detection scheme proposed by Yao and Womell. It extends this with the use of the well-known LLL algorithm, which enables the application to MIMO systems with arbitrary numbers of dimensions.

"Lattice-Reduction-Aided Receivers for MIMO-OFDM in Spatial Multiplexing Systems", (I. Berenguer, J. Adeane, I. Wassell and X. Wang, in Proc. Int. Symp. on Personal Indoor and Mobile Radio Communications, Sept. 2004, pp. 1517-1521, hereinafter referred to as "Berenguer et al.") describes the use of Orthogonal Frequency Division Multiplexing (OFDM) to significantly reduce receiver complexity in wireless systems with Multipath propagation, and notes its proposed use in wireless broadband multi-antenna (MIMO) systems.

Finally, "MMSE-Based Lattice-Reduction for Near-ML Detection of MIMO Systems", (D. Wubben, R. Bohnke, V. Kuhn and K. Kammeyer, in Proc. ITG Workshop on Smart Antennas, 2004, hereinafter referred to as "Wubben et al.") adopts the lattice-reduction aided schemes described above to the MMSE criterion.

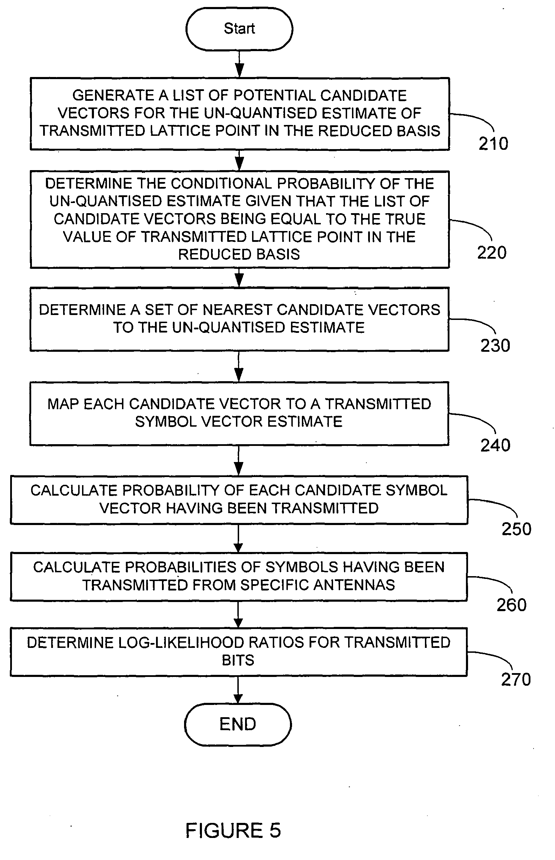

The techniques used in the publications described above use the concept that mathematically, the columns of the channel matrix, H, can be viewed as describing the basis of a lattice. An equivalent description of this lattice (a so-called 'reduced basis') can therefore be calculated so that the basis vectors are close to orthogonal. If the receiver then uses this reduced basis to equalise the channel, noise enhancement can be kept to a minimum and detection performance will improve (such as, as illustrated in Figure 5 in Wubben et al.). This process comprises the steps described as follows:

$\mathbf{y}_r$, $\mathbf{x}_r$ and $\mathbf{H}_r$ are defined to be the real-valued representations of $\mathbf{y}$, $\mathbf{x}$, and $\mathbf{H}$ respectively, such that:

$$\mathbf{y}_r = \begin{bmatrix} \text{Re}(\mathbf{y}) \\ \text{Im}(\mathbf{y}) \end{bmatrix}, \quad \mathbf{x}_r = \begin{bmatrix} \text{Re}(\mathbf{x}) \\ \text{Im}(\mathbf{x}) \end{bmatrix}, \quad \mathbf{H}_r = \begin{bmatrix} \text{Re}(\mathbf{H}) & -\text{Im}(\mathbf{H}) \\ \text{Im}(\mathbf{H}) & \text{Re}(\mathbf{H}) \end{bmatrix}$$

where Re() and Im() denote the real and imaginary components of their arguments.

It will be noted that Berenguer et al. describes the equivalent method in the complex field, though for the purpose of clarity the Real representation of the method is used herein.

A number of lattice reduction algorithms exist in the art. One suitable lattice reduction algorithm is the Lenstra-Lenstra-Lovasz (LLL) algorithm referred to above, which is disclosed in Wubben et al., and also in "Factoring Polynomials with Rational Coefficients", (A. Lenstra, H. Lenstra and L. Lovasz, Math Ann., Vol. 261, pp. 515-534, 1982, hereinafter referred to as "Lenstra et al."), and in "An Algorithmic Theory of Numbers, Graphs and Convexity", (L. Lovasz, Philadelpia, SIAM, 1980, hereinafter referred to as "Lovasz").

Any one of these can be used to calculate a transformation matrix, **T**, such that a reduced basis, $\tilde{\mathbf{H}}_r$, is given by

$$\tilde{\mathbf{H}}_r = \mathbf{H}_r \mathbf{T}$$

The matrix **T** contains only integer entries and its determinant is +/-1.

After lattice reduction, the system is re-expressed as:

$$\begin{aligned}
\mathbf{y}_r &= \mathbf{H}_r \mathbf{x}_r + \mathbf{v}_r \\
&= \mathbf{H}_r \mathbf{T} \mathbf{T}^{-1} \mathbf{x}_r + \mathbf{v}_r \\
&= \tilde{\mathbf{H}}_r \mathbf{T}^{-1} \mathbf{x}_r + \mathbf{v}_r \\
&= \tilde{\mathbf{H}}_r \mathbf{z} + \mathbf{v}_r
\end{aligned}$$

where $\mathbf{z}_r = \mathbf{T}^{-1}\mathbf{x}_r$. The received signal, $\mathbf{y}_r$, in this redefined system is then equalised to obtain an estimate of $\mathbf{z}_r$. This equalisation process then employs, for example, a linear ZF technique, which obtains:

$$\tilde{\mathbf{z}}_r = (\tilde{\mathbf{H}}_r^{*}\tilde{\mathbf{H}}_r)^{-1}\tilde{\mathbf{H}}_r^{*}\mathbf{y}_r$$

Since $\tilde{\mathbf{H}}_r$ is close to orthogonal, $\tilde{\mathbf{z}}_r$ should suffer much less noise enhancement than if the receiver directly equalised the channel $\mathbf{H}_r$.

Of course, other equalisation techniques could be used. For example, MMSE techniques, or more complex successive interference cancellation based methods, such as in the published prior art identified above, could be considered for use.

A receiver in accordance with the above operates in the knowledge that the transmitted symbols contained in **x** are obtained from an M-QAM constellation. With this constraint, $\tilde{\mathbf{z}}_r$ can then be quantised in accordance with the method indicated in Wubben et al.:

$$\hat{\mathbf{z}}_r = \alpha Q\left\{\frac{1}{\alpha}\left(\tilde{\mathbf{z}}_r - \mathbf{T}^{-1}\mathbf{1}\beta\right)\right\} + \mathbf{T}^{-1}\mathbf{1}\beta$$

where Q{} is the quantisation function that rounds each element of its argument to the nearest integer, and where 1 is a 2*m-by-1 vector of ones.

It will be understood from the above that, the quantisation function apart, the remaining operations are a result of M-QAM constellations being scaled and translated versions of the integer lattice. The integer quantisation therefore requires the same simple scaling and translation operations.

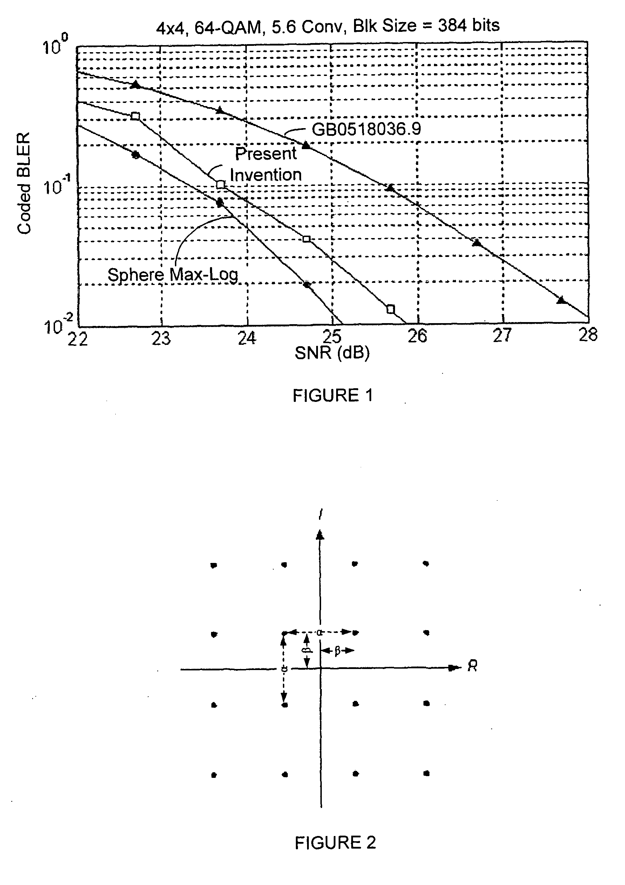

As shown in Figure 2, the scalar values $\alpha$ and $\beta$ are obtained from the definition of the M-QAM constellation in use, and $\alpha$ is equal to the minimum distance between two constellation points while $\beta$ corresponds to the minimum between the constellation points and the I/R axes (i.e. minimum offset from the origin in the I and R directions). In the present example, a 16-QAM constellation is used, having real and imaginary components of {+/-1, +/-3}.

Finally, the estimate $\hat{\mathbf{x}}_r$ of $\mathbf{x}_r$ is obtained by this method as

$$\hat{\mathbf{x}}_r = \mathbf{T}\hat{\mathbf{z}}_r$$

Occasionally, if errors are present in the estimate of $\hat{\mathbf{z}}_r$, then it is possible that some of the symbol estimates in $\hat{\mathbf{x}}_r$ may not be valid symbols. In such cases, these symbols are mapped to the nearest valid symbol. For example, for the present example employing 16-QAM, the values +/-1, +/-3 may define the valid entries in $\hat{\mathbf{x}}_r$. Therefore if a component of $\hat{\mathbf{x}}_r$ were, for example, equal to +5, then this would be mapped to a value of +3.

Such reduced lattice detectors (e.g. for MIMO systems) usually output hard decisions. The only mention in the literature of a technique that could be employed for obtaining soft-output is "From Lattice-Reduction-Aided Detection Towards Maximum-Likelihood Detection in MIMO Systems", (C. Windpassinger, L. Lampe and R. Fischer, in Proc. Int. Conf. on Wireless and Optical Communications, Banff, Canada, July 2003, hereinafter referred to as "Windpassinger et al."). The method that Windpassinger et al. proposes is complex, and the performance of this technique was not validated in the publication. Therefore it is an aim of aspects of the present invention to provide a MIMO detector capable of determining a soft output using a simple and proven approach.

A method of generating a list of candidate solutions by assuming that all elements of the hard decision vector, $\hat{\mathbf{z}}_r$, are equally reliable was described in the applicant's earlier UK patent application no. 0518036.9. That application describes an approach which involves generating a list by applying pre-determined perturbation to the quantised estimate provided by the reduced lattice detector. However, in general, the noise present in the elements of the un-quantised solution, $\tilde{\mathbf{z}}_r$, is different. Consequently, the reliability of the elements of $\hat{\mathbf{z}}_r$ can vary significantly. An aspect of the present invention provides a method of generating candidate solutions which recognises and takes into account the variation in reliability of different elements of the hard decision. This method generates a list of more likely candidate solutions and thus produces better quality soft information. Figure 1 demonstrates the benefit that can be obtained by computing better quality soft information.

Summary of the Invention

In general terms, an aspect of the present invention provides a method of obtaining log-likelihood ratios (LLRs) for bits at the output of a lattice reduction aided MIMO receiver.

In a first aspect of the present invention, there is provided a method for determining soft estimates of transmitted bit values from a received signal in a lattice-reduction-aided receiver based wireless communications system, the method comprising obtaining an estimate of channel response in a communication channel defined in the system, applying lattice reduction to said channel response and equalisation of said received signal in accordance with channel expressed in a reduced basis, and determining probabilities of transmitted bits having particular values by means of generating a list of candidate vectors in the reduced basis based on nearest candidate vectors, determining a corresponding transmitted symbol vector for each candidate vector and, on the basis of the received signal, determining the probability of each transmitted bit value having been transmitted.

Preferably, the step of generating a list of candidate vectors includes the step of selecting a list of potential candidate vectors by any one of:

(i) Setting the size of said list to a known fixed value, and;
(ii) Setting the size of said list to a predetermined number of valid candidate vectors, and varying the size until sufficient number of candidates are found.

In a preferred embodiment of the above aspect, there is provided the steps of determining a conditional probability of an estimated initial vector based on the condition of said potential candidate vectors being equal to true values of said initial vectors, and then determining said nearest candidate vectors based on said determined conditional probability.

Preferably, said nearest candidate vectors are nearest in the weighted squared Euclidean sense.

In another embodiment of the above aspect, there is provided the step of determining transmitted bit probabilities includes determining the probability of each candidate symbol vector having been transmitted and then determining the probabilities of all possible symbols having been transmitted from each of said transmitter antennas.

The method is suitable for use in a MIMO wireless communications system. Further, it can be used with any other system wherein a received signal is the result of transmission from a plurality of antennas, which may or may not be collocated. Further, the method is applicable to CDMA systems, such as multi-user detection (MUD).

Another aspect of the present invention provides a receiver for determining soft estimates of transmitted bit values from a received signal in a lattice-reduction-aided receiver based wireless communications system, comprising means for obtaining an estimate of the channel response, means for applying lattice reduction to said channel response, means for equalisation of the received signal in accordance with the reduced basis channel, and soft information determining means for determining probabilities of transmitted bits having particular values, said soft information determining means comprising means for generating a list of candidate vectors in the reduced basis based on nearest candidate vectors, means for determining a transmitted symbol vector for each candidate vector and, means for determining the probability of said transmitted bit value having been transmitted, on the basis of the received signal.

Another aim of the present invention is to provide a method for obtaining log-likelihood ratios (LLRs) for bits at the output of a lattice-reduction-aided MIMO receiver.

To this end, the probabilities determined in either the method above or by the detector above can be converted into LLRs.

Brief description of the drawings

Embodiments of the present invention will now be described with reference to the accompanying drawings, wherein:

Figure 1 illustrates a graph of performance obtained in accordance with an embodiment of the present invention and that obtained in accordance with an embodiment of the method disclosed in GB0518036.9 in comparison with a near-optimal practical max-log APP decoder for a coded system;

Figure 2 illustrates a graph of a lattice used in the wireless communications system of a specific embodiment of the invention, and used in the described examples of the prior art;

Figure 3 illustrates schematically a MIMO system including a transmitter and a receiver;

Figure 4 illustrates in further detail the receiver of figure 3; and

Figure 5 illustrates a detecting method operable by means of the detector illustrated in figure 4.

Detailed description

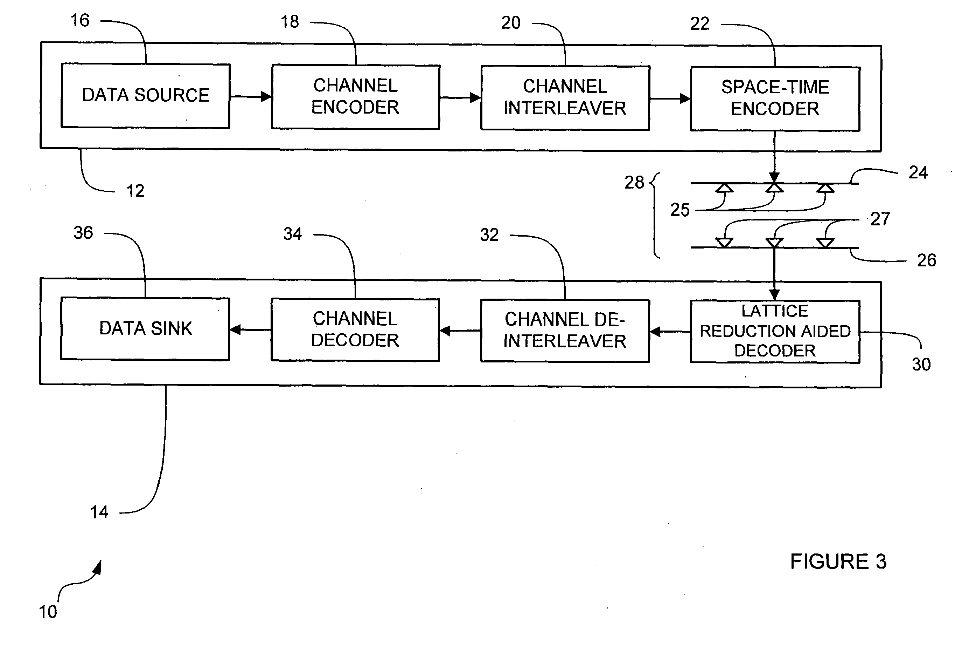

The present invention will now be described with reference to an implementation thereof for the equalization of a wireless communication system. Figure 3 illustrates such a system, comprising a MIMO data communications system 10 of generally known construction. New components, in accordance with a specific embodiment of the invention, will be evident from the following description.

The communications system 10 comprises a transmitter device 12 and a receiver device 14. It will be appreciated that in many circumstances, a wireless communications device will be provided with the facilities of a transmitter and a receiver in combination but, for this example, the devices have been illustrated as one way communications devices for reasons of simplicity.

The transmitter device 12 comprises a data source 16, which provides data (comprising information bits or symbols) to a channel encoder 18. The channel encoder 18 is followed by a channel interleaver 20 and, in the illustrated example, a space-time encoder 22. The space-time encoder 22 encodes an incoming symbol or symbols as a plurality of code symbols for simultaneous transmission from a transmitter antenna array 24 comprising a plurality of transmit antennas 25. In this illustrated example, three transmit antennas 25 are provided, though practical implementations may include more, or less antennas depending on the application.

The encoded transmitted signals propagate through a MIMO channel 28 defined between the transmit antenna array 24 and a corresponding receive antenna array 26 of the receiver device 14. The receive antenna array 26 comprises a plurality of receive antennas 27 which provide a plurality of inputs to a lattice-reduction-aided decoder 30 of the receiver device 14. In this specific embodiment, the receive antenna array 26 comprises three receive antennas 27.

The lattice-reduction-aided decoder 30 has the task of removing the effect of the MIMO channel 28. The output of the lattice-reduction-aided decoder 30 comprises a plurality of signal streams, one for each transmit antenna 25, each carrying so-called soft or likelihood data on the probability of a transmitted bit having a particular value. This data is provided to a channel de-interleaver 32 which reverses the effect of the channel interleaver 20, and the de-interleaved bits output by this channel de-interleaver 32 are then presented to a channel decoder 34, in this example a Viterbi decoder, which decodes the convolutional code. The output of channel decoder 34 is provided to a data sink 36, for further processing of the data in any desired manner.

The specific function of the lattice-reduction-aided decoder 30 will be described in due course.

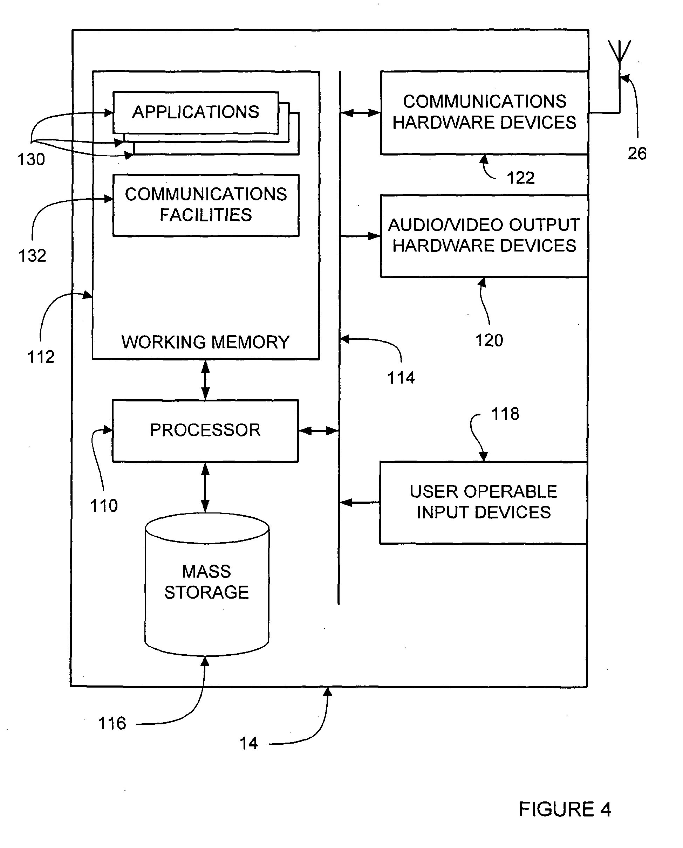

Figure 4 illustrates schematically hardware operably configured (by means of software or application specific hardware components) as the receiver device 14. The receiver device 14 comprises a processor 110 operable to execute machine code instructions stored in a working memory 112 and/or retrievable from a mass storage device 116. By means of a general purpose bus 114, user operable input devices 118 are capable of communication with the processor 110. The user operable input devices 118 comprise, in this example, a keyboard and a mouse though it will be appreciated that any other input devices could also or alternatively be provided, such as another type of pointing device, a writing tablet, speech recognition means, or any other means by which a user input action can be interpreted and converted into data signals.

Audio/video output hardware devices 120 are further connected to the general purpose bus 114, for the output of information to a user. Audio/video output hardware devices 120 can include a visual display unit, a speaker or any other device capable of presenting information to a user.

Communications hardware devices 122, connected to the general purpose bus 114, are connected to the antenna 26. In the illustrated embodiment in Figure 4, the working memory 112 stores user applications 130 which, when executed by the processor 110, cause the establishment of a user interface to enable communication of data to and from a user. The applications in this embodiment establish general purpose or specific computer implemented utilities that might habitually be used by a user.

Communications facilities 132 in accordance with the specific embodiment are also stored in the working memory 112, for establishing a communications protocol to enable data generated in the execution of one of the applications 130 to be processed and then passed to the communications hardware devices 122 for transmission and communication with another communications device. It will be understood that the software defining the applications 130 and the communications facilities 132 may be partly stored in the working memory 112 and the mass storage device 116, for convenience. A memory manager could optionally be provided to enable this to be managed effectively, to take account of the possible different speeds of access to data stored in the working memory 112 and the mass storage device 116.

On execution by the processor 110 of processor executable instructions corresponding with the communications facilities 132, the processor 110 is operable to establish communication with another device in accordance with a recognised communications protocol.

The function of the lattice-reduction aided decoder 30 will now be described in further detail in accordance with figure 5. This method as illustrated commences once the un-quantised estimate of the transmitted lattice point in the reduced basis, i.e. $\hat{\mathbf{z}}_r$, has been determined as outlined in the introduction and discussion of the prior art above. The manner in which this estimate is obtained is immaterial: any appropriate lattice reduction algorithm may have been used, and any of a number of equalisation methods may have been applied.

The estimate $\tilde{\mathbf{z}}_r$ is expressed as

$$\tilde{\mathbf{z}}_r = \mathbf{z}_r + \mathbf{n}$$

where $\mathbf{z}_r$ denotes the true value, as defined in the introduction and discussion of the prior art above, and n denotes the noise present in the estimate. Provided linear equalisation techniques are employed to compute $\tilde{\mathbf{z}}_r$, it is assumed that the elements of **n** are zero-mean Gaussian random variables. In general, the elements of **n** are thus characterised by the covariance matrix, **M**, given by

$$\mathbf{M} = E\left[\mathbf{n}\mathbf{n}^*\right].$$

where $E[]$ denotes statistical expectation. The covariance matrix, **M**, can be estimated using channel state information and the noise variance at the input of the reduced lattice detector. It will be understood that practical wireless systems are designed such that both of these parameters can be measured with sufficient accuracy using the channel estimation process.

In order to generate soft-outputs, a list of most likely candidate vectors for $\tilde{\mathbf{z}}_r$, herein denoted by

$\left\{\mathbf{c}_r^{(1)}, \mathbf{c}_r^{(2)}, \cdots, \mathbf{c}_r^{(K)}\right\}$, is required. In step 210 the list of $\left\{\mathbf{c}_r^{(1)}, \mathbf{c}_r^{(2)}, \cdots, \mathbf{c}_r^{(K)}\right\}$ is generated. The quality of soft-outputs can be improved by expanding the list size, K, until all candidate vectors have been included. However, in practice, only a small fraction of the total number of candidate vectors is required to produce sufficiently good soft-outputs.

The conditional probability of the observation $\tilde{\mathbf{z}}_r$ given that **c** is equal to $\mathbf{z}_r$ is performed in step 220, and is given as:

$$P\left(\widetilde{\mathbf{z}}_r \middle| \mathbf{z}_r = \mathbf{c}\right) = \frac{1}{\left(2\pi\right)^m \left(\det \mathbf{M}\right)^{1/2}} \exp\left[-\frac{1}{2}\left(\widetilde{\mathbf{z}}_r - \mathbf{c}\right)^* \mathbf{M}^{-1}\left(\widetilde{\mathbf{z}}_r - \mathbf{c}\right)\right].$$

In accordance with Lenstra et al., the lattice reduction process results in a modified system matrix, $\widetilde{\mathbf{H}}_r$, such that the columns of $\widetilde{\mathbf{H}}_r$ are nearly mutually-orthogonal. In this case, it can be shown that the off-diagonal elements of the covariance matrix **M** are close to zero i.e. the elements of **n** are nearly mutually-independent. Under this assumption, $(\widetilde{\mathbf{z}}_r\text{-}\mathbf{c})^*\mathbf{M}^{-1}(\widetilde{\mathbf{z}}_r\text{-}\mathbf{c})$ is equal to the *weighted squared Euclidean distance, $D(\widetilde{\mathbf{z}}_r,\mathbf{c})$*, given by

$$\left(\widetilde{\mathbf{z}}_r - \mathbf{c}\right)^* \mathbf{M}^{-1}\left(\widetilde{\mathbf{z}}_r - \mathbf{c}\right) = D\left(\widetilde{\mathbf{z}}_r, \mathbf{c}\right) = \sum_{i=1}^{2m} \frac{\left(\widetilde{z}_r[i] - c[i]\right)^2}{\sigma_i^2}$$

where

   $\widetilde{z}_r[i]$ denotes the *i*-th element of the vector $\widetilde{\mathbf{z}}_r$
   $c[i]$ denotes the *i*-th element of the vector **c** and

   $\sigma_i^2$ denotes the *i*-th diagonal element of the matrix **M**.

Therefore, in the case when **M** is diagonal, $P(\mathbf{z}_r = \mathbf{c}|\widetilde{\mathbf{z}}_r)$ is a monotonically decreasing function of the weighted squared Euclidian distance $D(\widetilde{\mathbf{z}}_r, \mathbf{c})$. Hence the set of *K* most likely candidate vectors, $\left\{\mathbf{c}_r^{(1)}, \mathbf{c}_r^{(2)}, \cdots, \mathbf{c}_r^{(K)}\right\}$ are the *K* nearest candidate vectors (in the weighted squared Euclidean sense) to the un-quantised estimate, $\widetilde{\mathbf{z}}_r$, in step 230.

The set of *K* nearest candidate vectors to $\widetilde{\mathbf{z}}_r$ can be computed very efficiently using techniques known *as k shortest path* algorithms as described in D. Eppstein, "Finding the k shortest paths", in Proc. 35 lh IEEE Symp. Foundations of Computer Science, Santa Fe, NM, 1994, pp 154-165. All nearest neighbour search algorithms operate iteratively i.e. in each iteration, the next closest neighbour is found from a list of potential candidates. In addition to this, the list of potential candidates is expanded in each iteration.

In step 240, each candidate vector, $\mathbf{c}_r^{(i)}$, is mapped to a corresponding symbol vector $\hat{\mathbf{x}}_r^{(i)}$ given by $\mathbf{x}_r^{(i)} = \mathbf{T}\mathbf{c}_r^{(i)}$. A candidate vector $\mathbf{c}_r^{(i)}$ is said to be valid if all elements of its corresponding symbol vector, $\hat{\mathbf{x}}_r^{(i)}$, are valid constellation symbols. Furthermore, some candidate vectors may map to symbol vectors whose elements may lie outside the signal constellation used for transmission.

The valid candidate symbols vectors are used to calculate soft-outputs. Thus the quality of the soft-outputs depends on the number of valid candidate vectors in the list $\left\{\mathbf{c}_r^{(1)}, \mathbf{c}_r^{(2)}, \cdots, \mathbf{c}_r^{(K)}\right\}$. There are two general approaches that may be taken in order to optimise performance (against complexity):

   (1) Set the list size K to a value that is known to contain a sufficient number of valid candidate vectors which provides the required detector performance. As the list size is fixed the complexity of the algorithm is also fixed using this approach.

   (2) Vary the list size K such that the list contains a pre-determined number of valid candidate vectors. With this approach, every time a candidate vector is found a check is performed to determine if it is valid and the candidate vector search is only terminated once sufficient number of valid candidates are found. Although the complexity will vary with this approach, the average complexity will be significantly lower than the above method.

For each valid candidate symbol vector $\hat{\mathbf{x}}_r^{(i)}$ the detector calculates, in step 250, its probability of being transmitted, as:

$$p^{(i)} = \frac{1}{\sqrt{\pi \sigma_v^2}} \exp\left( \frac{-\left\| \mathbf{y}_r - \mathbf{H}_r \hat{\mathbf{x}}_r^{(i)} \right\|}{\sigma_v^2} \right)$$

These probabilities are then used to calculate, in step 260, the probability of symbol *x'* having been transmitted from antenna k, where $x' \in X$ and X defines the set of symbols in the chosen constellation.

$$P(k, x') = \sum_{\{i | \hat{x}_k^{(i)} = x'\}} p^{(i)} \qquad \text{for } k = 1, \ldots, m \quad \text{and} \quad x' \in X$$

Depending on the list of candidates, according to the above definition P may not be specified for all values of k and *x'*. In these cases P is set to a default (small) value. This default can be a fixed value or it could varied according to a method such as that described in "Adaptive Selection of Surviving Symbol Replica Candidates Based on Maximum Reliability in QRM-MLD for OFCDM MIMO Multiplexing" (K. Higuchi, H. Kawai, N. Maeda and M. Sawahashi, in Proc. IEEE Globecom, Dallas, Dec. 2004), or by any other appropriate method.

Now that the receiver has information on the probability of different symbols having been transmitted, these are processed in the conventional way in step 270 to obtain a log-likelihood ratio for each transmitted bit. In the present example, this is done as follows:

$$L(b_{k,i}) = \log\left( \frac{\sum_{x' \in X^{(1)}} P(k, x')}{\sum_{x'' \in X^{(0)}} P(k, x'')} \right)$$

where $L(b_{k,i})$ is the log-likelihood ratio of bit $b_{k,i}$, k indicates the transmit antenna, i=1,...,M where M is the number of bits per symbol, and where X(1) and X(0) are the sets of symbols for which $b_{k,i}$ = 1 and $b_{k,i}$ = 0 respectively.

It will be appreciated that the foregoing disclosure of specific embodiments of the invention can be applied to any communications product employing MIMO transmission techniques, to take advantage of the benefits of the invention. Further, the invention is applicable to any circumstance in which the detection of symbols which may be based on multiple input is required. This could arise in systems where a plurality of antennas are provided in separate locations. Further, CDMA MUD may be a suitable basis for use of the method of the present invention.

The invention has been described by way of a software implementation. This software implementation can be introduced as a stand alone software product, such as borne on a storage medium, e.g. an optical disk, or by means of a signal. Further, the implementation could be by means of an upgrade or plug-in to existing software.

Whereas the invention can be so provided, it could also be by way exclusively by hardware, such as on an ASIC.

The reader will appreciate that the foregoing is but one example of implementation of the present invention, and that further aspects, features, variations and advantages may arise from using the invention in different embodiments. The scope of protection is intended to be provided by the claims appended hereto, which are to be interpreted in the light of the description with reference to the drawings and not to be limited thereby.

**Claims**

1. A method for determining soft estimates of transmitted bit values from a received signal in a lattice-reduction-aided receiver based wireless communications system, the method comprising obtaining an estimate of the channel response, applying lattice reduction to said channel response and equalisation of said received signal in accordance with the reduced basis channel, and determining probabilities of transmitted bits having particular values by means of generating a list of candidate vectors in the reduced basis based on nearest candidate vectors, determining a corresponding transmitted symbol vector for each candidate vector and, on the basis of the received signal determining the probability of each transmitted bit value having been transmitted.

2. A method in accordance with claim 1 wherein the step of generating a list of candidate vectors includes the step of selecting a list of potential candidate vectors by any one of:

(i) Setting the size of said list to a known fixed value, and;
(iii) Setting the size of said list to a predetermined number of valid candidate vectors, and varying the size until sufficient number of candidates are found.

3. A method in accordance with any preceding claim and further including the steps of determining a conditional probability of an estimated initial vectors based on the condition of said potential candidate vectors being equal to true values of said initial vectors, and then determining said nearest candidate vectors based on said determined conditional probability.

4. A method in accordance with claim 3 wherein said nearest candidate vectors are in the weighted square Euclidean sense.

5. A method in accordance with any preceding claim wherein the step of determining transmitted bit probabilities includes determining the probability of each candidate symbol vector having been transmitted and then determining the probabilities of all possible symbols having been transmitted from each of said transmitter antennas.

6. A method in accordance with claim 5 and further comprising the step of determining Log Likelihood Ratios (LLRs) from the determined probabilities.

7. A method in accordance with any preceding claim and wherein the lattice reduction is in accordance with the LLL algorithm.

8. A method in accordance with any preceding claim used in a MIMO communications system.

9. Apparatus for determining soft estimates of transmitted bit values from a received signal in a lattice-reduction-aided receiver based wireless communications system, comprising means for obtaining an estimate of the channel response, means for applying lattice reduction to said channel response, means for equalisation of the received signal in accordance with the reduced basis channel, and soft information determining means for determining probabilities of transmitted bits having particular values, said soft information determining means comprising means for generating a list of candidate vectors in the reduced basis based on nearest candidate vectors, means for determining a transmitted symbol vector for each candidate vector and, means for determining the probability of said transmitted bit value having been transmitted, on the basis of the received signal.

10. Apparatus in accordance with claim 9 wherein said means for generating said list of candidate vectors is operable to select a list of potential candidate vectors.

11. Apparatus in accordance with claim 9 or claim 10 including means for determining a conditional probability of an estimated initial vectors based on the condition of said potential candidate vectors being equal to true values of said initial vectors, and then to determine said nearest candidate vectors based on said determined conditional probability.

12. Apparatus in accordance with any one of claims 9 to 11 wherein said soft information determining means is operable to determine the probability of said symbol vector having been transmitted and then to determine the probabilities of all possible symbols having been transmitted from each of said transmitter antennas.

13. A MIMO wireless communications apparatus including a detector comprising apparatus in accordance with any one of claims 9 to 12.

14. A computer program product comprising computer executable instructions which, when executed on general purpose computer controlled communications apparatus, cause the apparatus to become configured to perform the method of any of claims 1 to 8.

15. A storage medium storing computer executable instructions which, when executed on general purpose computer controlled communications apparatus, cause the apparatus to become configured to perform the method of any of claims 1 to 8.

16. A signal carrying computer receivable information, the information defining computer executable instructions which, when executed on general purpose computer controlled communications apparatus, cause the apparatus to become configured to perform the method of any of claims 1 to 8.

4x4, 64-QAM, 5.6 Conv, Blk Size = 384 bits

FIGURE 1

FIGURE 2

FIGURE 3

EP 1 895 730 A1

FIGURE 4

Start

GENERATE A LIST OF POTENTIAL CANDIDATE
VECTORS FOR THE UN-QUANTISED ESTIMATE OF
TRANSMITTED LATTICE POINT IN THE REDUCED BASIS          210

DETERMINE THE CONDITIONAL PROBABILITY OF THE
UN-QUANTISED ESTIMATE GIVEN THAT THE LIST OF
CANDIDATE VECTORS BEING EQUAL TO THE TRUE
VALUE OF TRANSMITTED LATTICE POINT IN THE
REDUCED BASIS          220

DETERMINE A SET OF NEAREST CANDIDATE VECTORS
TO THE UN-QUANTISED ESTIMATE          230

MAP EACH CANDIDATE VECTOR TO A TRANSMITTED
SYMBOL VECTOR ESTIMATE          240

CALCULATE PROBABILITY OF EACH CANDIDATE SYMBOL
VECTOR HAVING BEEN TRANSMITTED          250

CALCULATE PROBABILITIES OF SYMBOLS HAVING BEEN
TRANSMITTED FROM SPECIFIC ANTENNAS          260

DETERMINE LOG-LIKELIHOOD RATIOS FOR TRANSMITTED
BITS          270

END

FIGURE 5

European Patent Office

**EUROPEAN SEARCH REPORT**

Application Number

EP 07 25 1679

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WINPASSINGER ET AL: "From lattice-reduction-aided detection towards maximum-likelihood detection in MIMO systems" INTERNET CITATION, [Online] July 2003 (2003-07), XP002433912 Retrieved from the Internet: URL:http://www.lnt.de/LIT/papers/WOC03.pdf > [retrieved on 2007-05-16] Sections III, IV, VII ----- | 1-16 | INV. H04L25/06 H04L25/03 |
| X | US 2003/076890 A1 (HOCHWALD BERTRAND MARTYN [US] ET AL) 24 April 2003 (2003-04-24) * page 5, paragraph 48 * * page 6, paragraph 72 * * page 9, paragraph 112 - paragraph 117 * ----- | 1,2,5,6, 8-10, 12-16 | |
| P,X, L | GB 2 429 884 A (TOSHIBA RES EUROP LTD [GB]) 7 March 2007 (2007-03-07) L: The priority of the application becomes uncertain * the whole document * ----- | 1,2, 5-10, 12-16 | TECHNICAL FIELDS SEARCHED (IPC) H04L |
| A | EP 1 521 414 A (TOKYO SHIBAURA ELECTRIC CO [JP]) 6 April 2005 (2005-04-06) * page 3, paragraph 11 - paragraph 12 * * page 4, line 32 - line 47 * * page 5, line 10 - line 20 * * page 6, paragraph 33 * * page 9, paragraph 46 * * page 12, paragraph 58 * * page 14, paragraph 69 * * figure 2c * ----- -/-- | 1-16 | |

The present search report has been drawn up for all claims

| Place of search | Date of completion of the search | Examiner |
|---|---|---|
| The Hague | 14 December 2007 | Moreno, Marta |

EPO FORM 1503 03.82 (P04C01)

**European Patent Office**

## EUROPEAN SEARCH REPORT

Application Number

EP 07 25 1679

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 724 843 B1 (CLARKSON KENNETH L [US] ET AL) 20 April 2004 (2004-04-20)<br>* column 2, line 35 - line 41 *<br>* column 9, line 44 - line 59 *<br>* column 11, line 50 - line 63 *<br>----- | 1-16 | |
| A | DONG-JIN LEE ET AL: "Near-Maximum Likelihood Detection of MIMO Systems Using Error Detection Scheme Based Lattice Reduction"<br>2006 ASIA-PACIFIC CONFERENCE ON COMMUNICATIONS,<br>31 August 2006 (2006-08-31), - 1 September 2006 (2006-09-01) pages 1-5, XP031002044<br>IEEE, Piscataway, NJ, USA<br>ISBN: 1-4244-0573-4<br>Section 3<br>----- | 1,7-9, 13-16 | |
| A | YI HONG ET AL: "A New approach for Iterative Decoding on Coded MIMO Channels via Sphere Decoding"<br>SPREAD SPECTRUM TECHNIQUES AND APPLICATIONS, 30 August 2004 (2004-08-30), - 2 September 2004 (2004-09-02) pages 520-524, XP010755088<br>IEEE, PISCATAWAY, NJ, USA<br>ISBN: 0-7803-8408-3<br>* page 521, column 2, last paragraph *<br>* page 523, column 1, last paragraph - column 2, paragraph 2 *<br>----- | 1,9 | TECHNICAL FIELDS SEARCHED (IPC) |

The present search report has been drawn up for all claims

| Place of search | Date of completion of the search | Examiner |
|---|---|---|
| The Hague | 14 December 2007 | Moreno, Marta |

EPO FORM 1503 03.82 (P04C01)

## EP 1 895 730 A1

### ANNEX TO THE EUROPEAN SEARCH REPORT
### ON EUROPEAN PATENT APPLICATION NO.

EP 07 25 1679

This annex lists the patent family members relating to the patent documents cited in the above-mentioned European search report.
The members are as contained in the European Patent Office EDP file on
The European Patent Office is in no way liable for these particulars which are merely given for the purpose of information.

14-12-2007

| Patent document cited in search report | | Publication date | Patent family member(s) | | Publication date |
|---|---|---|---|---|---|
| US 2003076890 | A1 | 24-04-2003 | NONE | | |
| GB 2429884 | A | 07-03-2007 | JP | 2007074729 A | 22-03-2007 |
| | | | US | 2007121753 A1 | 31-05-2007 |
| EP 1521414 | A | 06-04-2005 | WO | 2005034455 A1 | 14-04-2005 |
| | | | JP | 2007519281 T | 12-07-2007 |
| | | | US | 2005094742 A1 | 05-05-2005 |
| US 6724843 | B1 | 20-04-2004 | NONE | | |

EPO FORM P0459

For more details about this annex : see Official Journal of the European Patent Office, No. 12/82

18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- GB 0518036 A

### Non-patent literature cited in the description

- **H. YAO ; G.W. WOMELL.** Lattice-Reduction-Aided Detectors for MIMO Communication Systems. *Proc. IEEE Globecom,* November 2002, 424-428
- **C. WINDPASSINGER ; R. FISCHER.** Low-Complexity Near-Maximum-Likelihood Detection and Precoding for MIMO Systems using Lattice Reduction. *Proc. IEEE Information Theory Workshop,* March 2003, 346-348
- **I. BERENGUER ; J. ADEANE ; I. WASSELL ; X. WANG.** Lattice-Reduction-Aided Receivers for MIMO-OFDM in Spatial Multiplexing Systems. *Proc. Int. Symp. on Personal Indoor and Mobile Radio Communications,* September 2004, 1517-1521
- **D. WUBBEN ; R. BOHNKE ; V. KUHN ; K. KAMMEYER.** MMSE-Based Lattice-Reduction for Near-ML Detection of MIMO Systems. *Proc. ITG Workshop on Smart Antennas,* 2004
- **A. LENSTRA ; H. LENSTRA ; L. LOVASZ.** Factoring Polynomials with Rational Coefficients. *Math Ann,* 1982, vol. 261, 515-534
- An Algorithmic Theory of Numbers, Graphs and Convexity. SIAM, 1980
- **C. WINDPASSINGER ; L. LAMPE ; R. FISCHER.** From Lattice-Reduction-Aided Detection Towards Maximum-Likelihood Detection in MIMO Systems. *Proc. Int. Conf. on Wireless and Optical Communications,* July 2003
- **D. EPPSTEIN.** Finding the k shortest paths. *Proc. 35 IEEE Symp. Foundations of Computer Science,* 1994, 154-165
- **K. HIGUCHI ; H. KAWAI ; N. MAEDA ; M. SAWAHASHI.** Adaptive Selection of Surviving Symbol Replica Candidates Based on Maximum Reliability in QRM-MLD for OFCDM MIMO Multiplexing. *Proc. IEEE Globecom,* December 2004